(19) Europäisches Patentamt European Patent Office Office européen des brevets

(11) EP 1 770 790 A2

(12) EUROPEAN PATENT APPLICATION

(43) Date of publication:
04.04.2007 Bulletin 2007/14

(51) Int Cl.:
H01L 29/786 (2006.01)    H01L 21/336 (2006.01)

(21) Application number: 06254999.3

(22) Date of filing: 27.09.2006

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(30) Priority: 27.09.2005 KR 20050090134

(71) Applicant: Samsung SDI Co., Ltd.
Suwon-si,
Gyeonggi-do (KR)

(72) Inventors:
• Jeong, Jae Kyeong,
Legal & IP Team
Kiheung-eup
Yongin-si
Gyeonggi-do (KR)

• Shin, Hyun Soo,
Legal & IP Team
Kiheung-eup
Yongin-si
Gyeonggi-do (KR)
• Mo, Yeon Gon,
Legal & IP Team
Kiheung-eup
Yongin-si
Gyeonggi-do (KR)

(74) Representative: Mounteney, Simon James
Marks & Clerk
90 Long Acre
London WC2E 9RA (GB)

(54) **Transparent thin film transistor (TFT) and its method of manufacture**

(57) A transparent thin film transistor (TFT) and a method of fabricating the same are provided. The transparent TFT includes transparent source and drain electrodes formed of transparent material, a transparent semiconductor activation layer that contacts the source and drain electrodes, that is formed of transparent semiconductor, and in which source and drain regions are formed, and a doping section provided between the transparent source and drain electrodes and the transparent activation layer to have the same doping type as that of the source and drain regions and to have doping concentration different from that of the source and drain regions. At this time, doping during the formation of the doping section is performed by an in-situ method in which a gas containing impurities is sprayed in the same apparatus as the apparatus used for the previous step. Therefore, it is possible to reduce high contact resistance generated when the transparent semiconductor activation layer contacts the transparent electrodes and to thus form ohmic contact.

FIG. 1

EP 1 770 790 A2

## Description

## BACKGROUND OF THE INVENTION

### 1. Field of the Invention

The present invention relates to a transparent Thin Film Transistor (TFT) and its method of manufacture, and more particularly, to a transparent TFT in which an ohmic contact is formed between transparent electrodes and a transparent semiconductor activation layer.

### 2. Discussion of the Related Art

A Thin Film Transistor (TFT) can be applied to a light emitting device such as a flat panel display, a smart window, and a solar battery so that studies on the TFT are actively performed. In order to make the TFT transparent, a substrate, electrodes, a transparent semiconductor activation layer, and insulating layers are preferably formed of transparent or semi-transparent material.

An example of a transparent TFT is discussed in Japanese Laid-Open Patent Publication No. 2004-14982. The materials of the substrate, the electrodes, the transparent semiconductor activation layer, and the insulating layers are described in detail. For example, the substrate is formed of polyethylene terephthalate (PET) and polyethylene naphthalate (PEN), the electrodes are formed of a metal oxide layer such as an organic conductive material, Indium Tin Oxide (ITO), or ZnO, the transparent semiconductor activation layer is formed of an organic semiconductor in the acene family, such as pentacene and tetracene, and the insulating layers are formed of a poly acrylate, such as poly methyl methacrylate.

On the other hand, unlike in Japanese Laid-Open Patent Publication No. 2004-14982 where a transparent organic semiconductor is used, studies on transparent inorganic semiconductor materials are being conducted.

However, since transparent semiconductor materials that form the transparent semiconductor activation layer of the transparent TFT have a large band gap, it is difficult to form ohmic contacts between source and drain electrodes and the transparent semiconductor activation layer.

## SUMMARY OF THE INVENTION

Accordingly, it is an object of the present invention to provide a transparent Thin Film Transistor (TFT) in which ohmic contact is formed between electrodes and a transparent semiconductor activation layer.

It is another object of the present invention to provide a method of manufacturing a transparent TFT in which an ohmic contact is formed between the electrodes and the transparent semiconductor activation layer.

In order to achieve the foregoing and/or other objects of the present invention, according to an aspect of the present invention, a transparent Thin Film Transistor (TFT) is provided including: transparent source and drain electrodes; a transparent semiconductor activation layer arranged to contact the source and drain electrodes and having source and drain regions arranged therein; and a doping section arranged between the transparent source and drain electrodes and the transparent activation layer and having the same doping type as that of the source and drain regions and having a doping concentration different from that of the source and drain regions.

The doping section may comprise doping layers interposed between the source and drain electrodes and the transparent semiconductor. The doping section may comprise regions of the transparent semiconductor activation layer including a surface contacting the source and drain electrode.

The transparent semiconductor activation layer is preferably of a material selected from the group consisting of ZnO, ZnSnO, CdSnO, GaSnO, TISnO, InGaZnO, CuAIO, SrCuO, LaCuOS, GaN, InGaN, AlGaN, InGaAIN, SiC, and diamonds.

The source and drain electrodes are preferably of a material selected from the group consisting of Indium Tin Oxide (ITO), Indium Zinc Oxide (IZO), and Indium Tin Zinc Oxide (ITZO).

The source and drain regions are preferably p-type, and the doping section preferably has a p-type doping concentration higher than a doping concentration of a channel region.

The transparent semiconductor activation layer is preferably of a material selected from the group consisting of ZnO, ZnSnO, and InGaZnO, and the doping section is preferably doped with a material selected from the group consisting of N, P, and As. The transparent semiconductor activation layer is preferably SiC, and the doping section is preferably doped with either A1 or B. The transparent semiconductor activation layer is preferably of a material selected from the group consisting of GaN, InGaN, AlGaN, and InAlGaN, and the doping section is preferably doped with Mg.

The source and drain regions are preferably n-type, and the doping section preferably has an n-type doping concentration lower than a doping concentration of a channel region.

The transparent semiconductor activation layer is preferably SiC, and the doping section is preferably doped with either N or P. The transparent semiconductor activation layer is preferably of a material selected from the group consisting of InGaN, AlGaN, and InAlGaN, and the doping section is preferably doped with a material selected from the group consisting of Si, O, C, and Be.

In order to achieve the foregoing and/or other objects of the present invention, according to another aspect of the present invention, a method of manufacturing a transparent Thin Film Transistor (TFT) is provided, the method including: forming transparent source and drain electrodes of a transparent material: forming source and drain regions within a transparent semiconductor activation layer of a transparent semiconductor, the transparent semiconductor activation layer contacting the source and drain electrodes; forming a doping section doped with impurities, the doping section having the same doping type as that of the source and drain regions and having a doping concentration different from that of the source and drain regions.

The doping section is preferably doped by an in-situ method in which a gas containing impurities is sprayed in an apparatus used for forming the transparent semiconductor activation layer.

In order to achieve the foregoing and/or other objects of the present invention, according to yet another aspect of the present invention, a transparent Thin Film Transistor (TFT) is provided including: a gate electrode arranged on a substrate; a gate insulating layer arranged on the gate electrode; a transparent semiconductor activation layer of a first transparent semiconductor material arranged on the gate insulating layer and having source and drain regions arranged therein; doping layers of a second transparent semiconductor material arranged in at least parts of the source and drain regions on the transparent activation layer and having a same doping type as that of the source and drain regions and having a same doping concentration as that of the source and drain regions; and transparent source electrodes and drain electrodes arranged in at least one region of the regions in which the doping layers are arranged.

The first transparent semiconductor material is preferably selected from the group consisting of ZnO, ZnSnO, CdSnO, GaSnO, TlSnO, InGaZnO, CuAlO, SrCuO, LaCuOS, GaN, InGaN, AlGaN, InGaAlN, SiC, and diamonds.

The second transparent semiconductor material is preferably the same as the first transparent semiconductor material.

The source and drain electrodes are preferably of a material selected from the group consisting of ITO, IZO, and ITZO.

The gate electrode, the gate insulating layer, and the doping layers are preferably of a transparent material.

The thickness of the doping layers is preferably in a range of from 10 to 100nm.

The source and drain regions are preferably p-type, and the doping layers preferably have a p-type doping concentration higher than the doping concentration of the source and drain regions.

The transparent semiconductor material is preferably selected from the group consisting of ZnO, ZnSnO, and InGaZnO, and the doping section is preferably doped with a material selected from the group consisting of N, P, and As. The transparent semiconductor material is preferably SiC, and the doping section is preferably doped with either Al or B. The transparent semiconductor material is preferably selected from the group consisting of GaN, InGaN, AlGaN, and InAlGaN, and the doping section is preferably doped with Mg.

The source and drain regions are preferably n-type, and the doping section preferably has an n-type doping concentration lower than the doping concentration of the channel region.

The transparent semiconductor material is preferably SiC, and the doping section is preferably doped with either N or P. The transparent semiconductor material is preferably selected from the group consisting of InGaN, AlGaN, and InAlGaN, and the doping section is preferably doped with a material selected from the group consisting of Si, O, C, and Be.

In order to achieve the foregoing and/or other objects of the present invention, according to yet another aspect of the present invention, a method of manufacturing a transparent Thin Film Transistor (TFT) is provided, the method including: forming a gate electrode; forming a gate insulating layer on the gate electrode; forming a transparent semiconductor activation layer of first transparent semiconductor on the gate insulating layer and having source and drain regions formed therein; forming doping layers of a second transparent semiconductor in at least parts of the source and drain regions on the transparent semiconductor activation layer and having a same doping type as that of the source and drain regions and having a doping concentration different from that of the source and drain regions; etching the doping layers to divide them into two regions; and forming transparent source and drain electrodes on the doping layers.

The doping layers are preferably doped by an in-situ method in which a gas containing impurities is sprayed in an apparatus used for forming the transparent semiconductor activation layer.

A recess etching method of etching the upper part of the transparent activation layer to a predetermined thickness is preferably used in etching the doping layers.

According to the transparent TFT of embodiments of the present invention and its method of manufacture, it is possible to remove an energy barrier which occurs when the transparent semiconductor activation layer contacts the electrodes so that it is possible to improve ohmic contact between the transparent semiconductor activation layer and the electrodes.

According to the transparent TFT of embodiments of the present invention, ohmic contact is formed between the electrodes and the transparent semiconductor activation layer so that it is possible to improve emission efficiency and stability.

## BRIEF DESCRIPTION OF THE DRAWINGS

A more complete appreciation of the present invention and many of the attendant advantages thereof, will be readily apparent as the present invention becomes better understood by reference to the following detailed description when considered in conjunction with the accompanying drawings in which like reference symbols indicate the same or similar components, wherein:

FIG. 1 is a sectional view of the structure of a transparent Thin Film Transistor (TFT) according to a first embodiment of the present invention;

FIG. 2 is a flowchart of the processes of manufacturing the transparent TFT according to the first embodiment of the present invention;

FIG. 3 is a sectional view of the structure of a transparent TFT according to a second embodiment of the present invention; and

FIG. 4 is a flowchart of the processes of manufacturing the transparent TFT according to the second embodiment of the present invention.

## DETAILED DESCRIPTION OF THE INVENTION

Hereinafter, exemplary embodiments of the present invention are described in detail with reference to the attached drawings. In this specification, the term "transparency" generally indicates not only relatively high transparency in which light having a wavelength of 300~700nm is transmitted by 50% or more, but also relatively low transparency in which the light is transmitted by 20 to 50%.

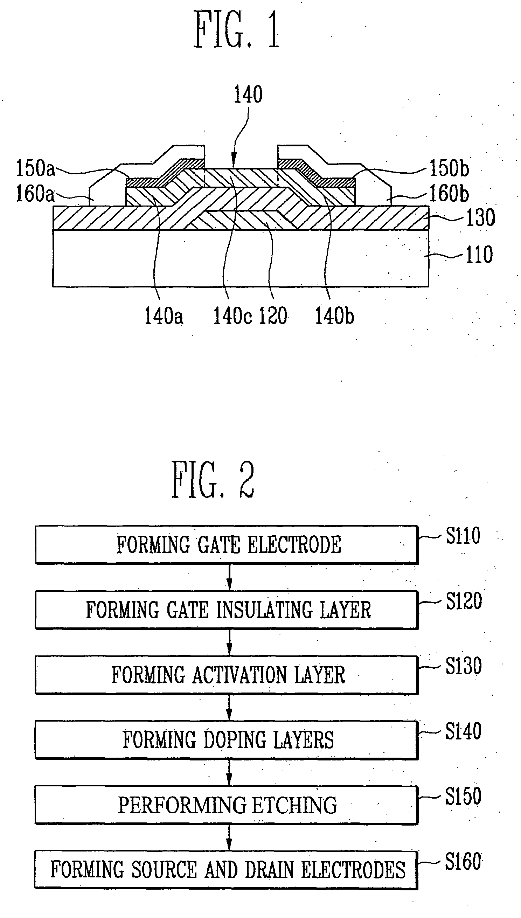

FIG. 1 is a sectional view of a bottom gate transparent Thin Film Transistor (TFT) according to a first embodiment of the present invention. Referring to FIG. 1, a transparent TFT includes a substrate 110, a gate electrode 120, a gate insulating layer 130, a transparent semiconductor activation layer 140, doping layers 150a and 150b and transparent source and drain electrodes 160a and 160b. Since the components of a common TFT are well known to one skilled in the art, the components that are related to the aspects of the present invention will be simply described.

The substrate 110, which is an insulating substrate, can be formed of glass and is preferably formed of transparent synthetic resin that is light and flexible.

The gate electrode 120 is formed on the substrate in a predetermined pattern and can be formed of Indium Tin Oxide (ITO), Indium Zinc Oxide (IZO), Indium Tin Zinc Oxide (ITZO), or a semi-transparent metal.

The gate insulating layer 130 is formed on the gate electrode of an inorganic or organic insulating material and is preferably formed of a transparent material.

The transparent activation layer 140 is formed on the gate insulating layer 130 of transparent semiconductor. Oxides such as ZnO, ZnSnO, CdSnO, GaSnO, TlSnO, InGaZnO, CuAlO, SrCuO, and LaCuOS, nitrides such as GaN, InGaN, AlGaN, and InGaAlN, and carbides such as SiC and diamonds can be used as the transparent semiconductor. The transparent semiconductor activation layer 140 is formed to a thickness of about 300 to 2,000Å. The transparent semiconductor activation layer 140 is doped with impurities to form the source and drain regions 140a and 140b.

A host formed of the transparent semiconductor is doped with impurities to form the doping layers 150a and 150b. The transparent semiconductor of the doping layers can be formed of the same material as that of the transparent semiconductor activation layer 140 and is preferably formed of the same material for convenience sake.

In the case of silicon semiconductors, group V elements, such as P and As, are used as n-type impurities and group III elements, such as B and Al, are used as p-type impurities. However, in the case of no less than a binary inorganic semiconductor, since stoichiometry among the respective components must be considered, a common dopant does not exist but rather the dopant varies with the inorganic semiconductor system.

Therefore, instead of designating the doping materials of the oxide, nitride, and carbide based inorganic semiconductor layers, respectively, the doping material of ZnO semiconductor that is one of the most suitable materials of the transparent semiconductor activation layer will be taken as an example. In this case, an n-type semiconductor is deposited without performing intentional doping, which is because lattice defects of oxygen void porosities Vo or Zn interstial (Zni). On the other hand, elements such as N, P, and As can be used as p-type dopant. This is because the group V element operates as a donor in the case of silicon; however, the group V element occupies the place of oxygen to operate as an acceptor in the case of ZnO. Therefore, in the case of an NMOS device, the ratio of Zn/O is supplied to a reactor to form $n^+$ doping layers 150a and 150b. In the case of a PMOS device, the dopant gas such as N, P, and As is supplied to the reactor to form $p^+$ doping layers 150a and 150b.

The same method can be used for ZnSnO that is ZnO based semiconductor. That is, in the case of the ZnO and ZnSnO semiconductors, it is preferable to increase the flux of Zn and to reduce oxygen voltage division in order to perform n-type doping and to supply a gas containing the group V element, such as N, P, and As, to a reaction chamber in order to perform p-type doping.

The doping layers 150a and 150b are provided in at least a region on the source and drain regions 140a and 140b. The thickness of the doping layers 150a and 150b is preferably 10 to 100nm. When the thickness is no more than 10nm, the doping layers 150a and 150b do not operate well so that it is difficult to form ohmic contacts. When the thickness is no less than 100nm, on-resistance and processing cost is increased. The doping layers 150a and 150b are doped in the same type as the source and drain regions 140a and 140b and the doping concentration of the doping layers 150a and 150b are different from the doping concentration of the source and drain regions 140a and 140b.

That is, when the source and drain regions 140a and 140b are p-type, the doping layers 150a and 150b are preferably doped to have a $p^+$-type concentration higher than that of the transparent source and drain regions 140a and 140b. When the source and drain regions 140a and 140b are n-type, the doping layers 150a and 150b are preferably doped to have an n$^+$-type concentration lower than that of the source and drain regions 140a and 140b.

This is because the width W of the Schottky barrier of electrons formed when n-type semiconductor contacts metal layers is significantly reduced when the metal layers contact n$^+$ doping layers

$$\left( W \propto 1 / \sqrt{N_D} \right.,$$

wherein, $W$ and $N_D$ represent the width of a depletion layer and n-type doping concentration, respectively) so that tunneling increases to realize an ohmic contact. The width of the Schottky barrier of electrons formed when p-type semiconductor contacts the metal layers is significantly reduced when p$^+$ doping layers contact the metal layers so that tunneling increases to realize an ohmic contact.

Therefore, when the doping layers are heavily doped with proper impurities in accordance with the type of transparent semiconductor that it contacts, an ohmic contact is formed between the doping layers and the electrodes.

The transparent source and drain electrodes 160a and 160b are formed in a region on the doping layers 150a and 150b and can be formed of ITO, IZO, ITZO, or a semi-transparent metal.

Hereinafter, a method of manufacturing the transparent TFT according to the present embodiment is described with reference to FIGs. 1 and 2. According to the method of the embodiment, the components that are not related to aspects of the present invention will be simply described. The method according to the first embodiment includes step S110 of forming a gate electrode, step S120 of forming an insulating layer, step S130 of forming transparent semiconductor activation layer, step S140 of forming doping layers, an etching step S150, and step S160 of forming source and drain electrodes.

In the gate electrode forming step S 110, an electrode layer formed of the above-described electrode forming material is formed by a sputtering or deposition method and then, the electrode layer is patterned by a photolithography or lift-off method.

In the insulating layer forming step S120, an insulating layer is formed in the gate electrode 110 by a coating method and a printing method when the insulating layer is an organic insulating layer and by a Chemical Vapor Deposition (CVD) method and a System on Glass (SOG) method when the insulating layer is an inorganic insulating layer.

In the transparent semiconductor activation layer forming step S 130, the transparent semiconductor activation layer 140 is formed on the insulating layer 130 of transparent semiconductor by the CVD method, a Pulse Laser Deposition (PLD) method, an Atomic Layer Deposition (ALD) method, a sputtering method, or a Molecular Beam Epitaxy (MBE) method. A mask that covers a region 140c to be a channel is formed and a semiconductor layer region is doped using the mask so that the source and drain regions 140a and 140b are formed.

In the doping layer forming step S 140, the doping layers 150a and 150b doped with impurities are formed on the transparent semiconductor activation layer 140. First, the transparent semiconductor activation layer 140 is formed and then, impurities are implanted so that the doping layers 150a and 150b are formed. The transparent semiconductor activation layer can be formed by the CVD method and the sputtering method. Since the doping layers 150a and 150b are preferably formed by the same method as the method of forming the transparent semiconductor activation layer 140 and in the same apparatus as the apparatus in which the transparent semiconductor activation layer 140 is formed, in a method of implanting impurities, application of an ion implantation method is not limited. However, an in-situ method in which doping is performed on the spot without moving the substrate is preferably used. That is, it is preferable to form a transparent semiconductor activation layer into which impurities are not implanted and then, to spray a gas containing impurity elements onto the transparent semiconductor activation layer so that doping is performed without moving the substrate to another chamber.

In the etching step S 150, the doping layers 150a and 150b are etched so that the doping layers 150a and 150b are formed on the source and drain regions and that the doping layers 150a and 150b are divided into two. The doping layers 150a and 150b are selectively etched using a mask. It is preferable to perform recess etching in which the upper layer of the transparent semiconductor activation layer 140 is also etched to a predetermined thickness.

In the source and drain electrode forming steps S160, deposition is performed on the doping layers by the CVD method and the sputtering method to perform patterning in a predetermined shape.

On the other hand, the transparent TFT according to the present embodiment can be manufactured by a method different from the above-described method. The method is similar to the above-described method, however, is different from the above-described method where the transparent semiconductor activation layer 140 and the doping layers 150a and 150b are separately formed in that the transparent semiconductor activation layer 140 is formed to be thicker than the transparent semiconductor activation layer formed by the above-described method and that the transparent semiconductor activation layer is doped with impurities to form the doping layers 150a and 150b to a predetermined thickness. In this case, it is possible to simplify processes of forming the doping layers 150a and 150b.

Hereinafter, a second embodiment of the present invention is described. FIG. 3 is a sectional view of a coplanar transparent TFT according to the second embodiment of the present invention. Referring to FIG. 3, the coplanar transparent TFT includes a substrate 210, a transparent semiconductor activation layer 240 (240a, 240b, 240c, 250a, and 250b), a gate insulating layer 230, a gate electrode 220, an interlayer insulating layer 270, and transparent source and drain electrodes 260a and 260b.

The substrate 210, which is an insulating substrate, can be formed of glass and is preferably formed of transparent synthetic resin that is light and flexible.

The transparent semiconductor activation layer 240 (240a, 240b, 250a, and 250b) is formed on the substrate 210 of a transparent semiconductor. Oxides such as ZnO, ZnSnO, CdSnO, GaSnO, TISnO, InGaZnO, CuAlO, SrCuO, and LaCuOS, nitrides such as GaN, In-GaN, AlGaN, and InGaAlN, and carbides such as SiC and diamonds can be used as the transparent semiconductor. The transparent semiconductor activation layer 240 includes source and drain regions 240a and 240b formed on both sides thereof and doping regions 250a and 250b formed on the source and drain regions 240a and 240b.

The doping type of the doping regions 250a and 250b is the same as the doping type of the source and drain regions 240a and 240b and the doping concentration of the doping regions 250a and 250b is different from the doping concentration of the source and drain regions 240a and 240b. For example, when the source and drain regions 240a and 240b are p-type, the doping type of the doping regions 250a and 250b is p-type and the doping concentration of the doping regions 250a and 250b is higher than the doping concentration of a channel region 240c. When the source and drain regions 240a and 240b are n-type, the doping type of the doping regions 250a and 250b is n-type and the doping concentration of the doping regions 250a and 250b is lower than the doping concentration of the source and drain regions 240a and 240b.

The gate insulating layer 230 is formed on the transparent semiconductor activation layer and can be formed of a transparent inorganic or organic insulating layer.

The gate electrode 220 is formed on the gate insulating layer 230 to correspond to the channel region 240c and can be formed of transparent ITO, IZO, or ITZO or a semi-transparent metal.

The interlayer insulating layer 270 is formed on the gate electrode 220 and the gate insulating layer 230 and includes contact holes 280a and 280b so that source and drain electrodes 260a and 260b to be mentioned later can contact the source and drain regions 240a and 240b. The interlayer insulating layer 270 can be formed of SiNx and SiO2.

The transparent source and drain electrodes 260a and 260b are formed on the interlayer insulating layer 270 while contacting the doping regions 250a and 250b on the source and drain regions 240a and 240b through the contact holes 280a and 280b. The source and drain electrodes 260a and 260b are formed of transparent ITO, IZO, or ITZO or a semi-transparent metal like the source and drain electrodes 240a and 240b.

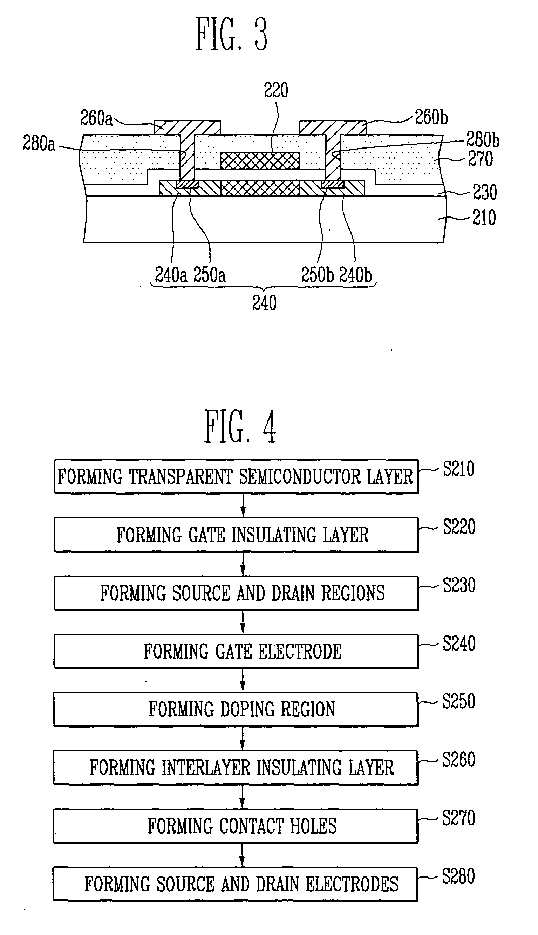

Hereinafter, a method of manufacturing the transparent TFT according to the second embodiment of the present invention is described with reference to FIGs. 3 and 4. FIG. 4 is a flowchart of processes of manufacturing the transparent TFT according to the second embodiment of the present invention. Referring to FIG. 4, the method of forming the transparent TFT according to the second embodiment includes step S210 of forming a transparent semiconductor activation layer, step S220 of forming a gate insulating layer, step S230 of forming source and drain regions, step S240 of forming a gate electrode, step S250 of forming doping regions, step S260 of forming an interlayer insulating layer, step S270 of forming contact holes, and step S280 of forming source and drain electrodes.

In the transparent semiconductor activation layer forming step S210, the transparent semiconductor activation layer 240 is formed on a substrate where a buffer layer is selectively formed using a mask. The transparent semiconductor activation layer 240 is formed of a transparent semiconductor.

In the gate insulating layer forming step S220, the gate insulating layer 230 is formed on the transparent semiconductor activation layer 240. When the insulating layer is an organic insulating layer, the coating method and the printing method can be used. When the insulating layer is an inorganic insulating layer, a thermal oxidation method, the CVD method, and the SOG method can be used.

In the source and drain region forming step S230, parts formed to be the source and drain regions 240a and 240b in the transparent semiconductor activation layer 240 are formed on the gate insulating layer 230. A mask that covers the region excluding the parts formed to be the source and drain regions is formed and the transparent semiconductor activation layer is doped using the mask so that the source and drain regions 240a and 240b are formed.

In the gate electrode forming steps S240, after removing the mask used for the source and drain electrode forming step S230, a metal layer is formed on a gate insulating layer 260 and the metal layer formed on the gate insulating layer 260 is patterned so that the gate electrode 220 is formed.

In the doping region forming step S250, the doping regions 250a and 250b are formed on the transparent semiconductor activation layer 240 using a mask. The doping regions 250a and 250b are formed on the source and drain regions 240a and 240b so that the doping regions 250a and 250b directly contact the source and drain electrodes 240a and 240b.

In the interlayer insulating layer forming step S260, after the doping regions 250a and 250b are formed, the inorganic or organic interlayer insulating layer 270 is formed on the gate electrode 220. One or more interlayer insulating layers 270 can be used and the interlayer insulating layer 270 is preferably transparent.

In the contact hole forming step S270, a plurality of contact holes 280a and 280b that expose the source and drain regions 240a and 240b are formed in the interlayer insulating layer 270 and the gate insulating layer 230. The contact holes 280a and 280b can be formed at the same time through the process of simultaneously etching the gate insulating layer 230 and the interlayer insulating layer 270.

Finally, in the source and drain electrode forming step S280, after the contact holes 280a and 280b are formed, the source and drain electrodes 260a and 260b of the TFT are formed of the above-described material. That the source and drain electrodes 260a and 260b contact the doping regions 250a and 250b is as noted above. The source and drain electrodes 260a and 260b are formed by the sputtering method or the CVD method and are patterned by the photolithography method or the lift off method.

Although exemplary embodiments of the present invention have been disclosed for illustrative purposes, those skilled in the art will appreciate that various modifications, additions and substitutions are possible, without departing from the scope of the present invention as defmed by the accompanying claims. For example, bottom gate type and coplanar TFTs were described with reference to the above embodiments. However, it is apparent to one skilled in the art that modifications of embodiments of the present invention can be applied to other structures. Also, common deposition and etching methods that are not described in the specification can be easily conceived by one skilled in the art.

**Claims**

1. A transparent Thin Film Transistor (TFT) comprising:

   a transparent source electrode and a transparent drain electrode;
   a transparent semiconductor activation layer arranged to contact the source and drain electrodes and having source and drain regions arranged therein; and
   a doping section arranged between at least one of the transparent source and drain electrodes and the transparent activation layer and having the same doping type as that of the source and drain regions and having a doping concentration that is different from that of the source and drain regions.

2. A transparent TFT according to claim 1, wherein the doping section comprises two doping layers, each said doping layer being disposed between one of the source and drain electrodes and the transparent semiconductor.

3. A transparent TFT according to claim 1, wherein the doping section comprises two regions of the transparent semiconductor activation layer, each said region of the transparent semiconductor activation layer including a surface contacting one of the source and drain electrodes.

4. A transparent TFT according to any one of claims 1 to 3, wherein the source and drain regions are p-type, and wherein the doping section has a p-type doping concentration higher than a doping concentration of a channel region.

5. A transparent TFT according to claim 4, wherein the transparent semiconductor activation layer is formed of a material selected from the group consisting of ZnO, ZnSnO, and InGaZnO, and wherein the doping section is doped with a material selected from the group consisting of N, P, and As.

6. A transparent TFT according to claim 4, wherein the transparent semiconductor activation layer is formed of SiC, and wherein the doping section is doped with either A1 or B.

7. A transparent TFT according to claim 4, wherein the transparent semiconductor activation layer is formed of a material selected from the group consisting of GaN, InGaN, AlGaN, and InAlGaN, and wherein the doping section is doped with Mg.

8. A transparent TFT according to any one of claims 1 to 3, wherein the source and drain regions are n-type, and wherein the doping section has an n-type doping concentration lower than a doping concentration of a channel region.

9. A transparent TFT according to claim 8, wherein the transparent semiconductor activation layer is formed of SiC, and wherein the doping section is doped with either N or P.

10. A transparent TFT according to claim 8, wherein the transparent semiconductor activation layer is formed of a material selected from the group consisting of InGaN, AlGaN, and InAlGaN, and wherein the doping section is doped with a material selected from the group consisting of Si, O, C, and Be.

11. A transparent TFT according to any preceding claim, further comprising:

    a gate electrode arranged on a substrate;
    a gate insulating layer arranged on the gate electrode; wherein:

       the transparent semiconductor activation layer is formed of a first transparent semiconductor material arranged on the gate insulating layer;

the doping section is formed of a second transparent semiconductor material.

12. A transparent TFT according to claim 11, wherein the first transparent semiconductor material is selected from the group consisting of ZnO, ZnSnO, CdSnO, GaSnO, TlSnO, InGaZnO, CuAlO, SrCuO, LaCuOS, GaN, InGaN, AlGaN, InGaAlN, SiC, and diamonds.

13. A transparent TFT according to claim 12, wherein the second transparent semiconductor material is the same as the first transparent semiconductor material.

14. A transparent TFT according to any one of Claims 11 to 13, wherein the source and drain electrodes are formed of a material selected from the group consisting of ITO, IZO, and ITZO.

15. A transparent TFT according to any one of Claims 11 to claim 14, wherein the gate electrode, the gate insulating layer, and the doping layers are formed of a transparent material.

16. A transparent TFT according to any one of the preceding claims when dependent on claim 2, wherein the thickness of the doping layers is in a range of from 10 to 100nm.

17. A transparent TFT according to any one of Claims 1 to 4 or Claims 11 to 16, wherein the source and drain regions are p-type, and wherein the doping section has a p-type doping concentration higher than the doping concentration of the source and drain regions.

18. A transparent TFT according to claim 17, wherein the transparent semiconductor material is selected from the group consisting of ZnO, ZnSnO, and InGaZnO, and wherein the doping section is doped with a material selected from the group consisting of N, P, and As.

19. A transparent TFT according to claim 17, wherein the transparent semiconductor material is SiC, and wherein the doping section is doped with either Al or B.

20. A transparent TFT according to claim 17, wherein the transparent semiconductor material is selected from the group consisting of GaN, InGaN, AlGaN, and InAlGaN, and wherein the doping section is doped with Mg.

21. A transparent TFT according to any one of Claims 1 to 3 or Claims 8 to 16, wherein the source and drain regions are n-type, and wherein the doping section has an n-type doping concentration lower than the doping concentration of the channel region.

22. A transparent TFT according to claim 21, wherein the transparent semiconductor material is formed of SiC, and wherein the doping section is doped with either N or P.

23. A transparent TFT according to claim 21, wherein the transparent semiconductor material is selected from the group consisting of InGaN, AlGaN, and InAlGaN, and wherein the doping section is doped with a material selected from the group consisting of Si, O, C, and Be.

24. A method of manufacturing a transparent Thin Film Transistor (TFT), the method comprising:

forming transparent source and drain electrodes comprising a transparent material:

forming a transparent semiconductor activation layer comprising a transparent semiconductor, the transparent semiconductor activation layer contacting the source and drain electrodes and having source and drain regions arranged therein; forming a doping section doped with impurities, the doping section having the same doping type as that of the source and drain regions and having a doping concentration that is different from that of the source and drain regions.

25. A method according to claim 24, further comprising:

forming a gate electrode; forming a gate insulating layer on the gate electrode; forming the transparent semiconductor activation layer from a first transparent semiconductor on the gate insulating; forming the doping section as a layer of a second transparent semiconductor; etching the doping layer to divide it into two regions; and forming transparent source and drain electrodes on a respective region of a doping layer.

26. A method according to claim 25, wherein a recess etching method of etching the upper part of the transparent activation layer to a predetermined thickness is used in etching the doping layers.

27. A method according to any one of claims 24 to 26, wherein the doping section is doped by an in-situ method in which a gas containing impurities is sprayed in an apparatus used for forming the transparent semiconductor activation layer.

28. A flat panel display comprising a TFT according to any one of claims 1 to 22.

29. A transparent Thin Film Transistor (TFT) comprising:

a gate electrode arranged on a substrate;
a gate insulating layer arranged on the gate electrode;
a transparent semiconductor activation layer of a first transparent semiconductor material arranged on the gate insulating layer and having source and drain regions arranged therein;
doping layers of a second transparent semiconductor material arranged in at least parts of the source and drain regions on the transparent activation layer and having a same doping type as that of the source and drain regions and having a same doping concentration as that of the source and drain regions; and
transparent source electrodes and drain electrodes arranged in at least one region of the regions in which the doping layers are arranged.

# FIG. 1

# FIG. 2

| | |
|---|---|
| FORMING GATE ELECTRODE | S110 |
| FORMING GATE INSULATING LAYER | S120 |
| FORMING ACTIVATION LAYER | S130 |
| FORMING DOPING LAYERS | S140 |
| PERFORMING ETCHING | S150 |
| FORMING SOURCE AND DRAIN ELECTRODES | S160 |

# FIG. 3

260a    220    260b
280a    280b
270
230
210

240a 250a    250b 240b
240

# FIG. 4

| |
|---|
| FORMING TRANSPARENT SEMICONDUCTOR LAYER |— S210
| FORMING GATE INSULATING LAYER |— S220
| FORMING SOURCE AND DRAIN REGIONS |— S230
| FORMING GATE ELECTRODE |— S240
| FORMING DOPING REGION |— S250
| FORMING INTERLAYER INSULATING LAYER |— S260
| FORMING CONTACT HOLES |— S270
| FORMING SOURCE AND DRAIN ELECTRODES |— S280

**REFERENCES CITED IN THE DESCRIPTION**

**Patent documents cited in the description**

- JP 2004014982 A